# EUROPEAN PATENT APPLICATION

(11) **EP 4 029 574 A1**
(43) Date of publication of application: **20.07.2022**
(21) Application number: 20863305.7
(22) Date of filing: 03.09.2020
(51) Int. Cl.: A63B 22/02, A61H 1/02, A63B 23/04, A63B 24/00, H01L 41/06, H01L 41/113, H01L 41/193

(54) **TREADMILL**

(30) Priority: 12.09.2019 JP 2019166013
(71) Applicant: Ohtake Root Kogyo Co., Limited, Ichinoseki-city, Iwate, 021-0902 (JP)
(72) Inventor: OTA, Yoshitake, Ichinoseki-shi, Iwate 021-0902 (JP); TAKAHASHI, Hiroshi, Ichinoseki-shi, Iwate 021-0902 (JP); MATSUMOTO, Manabu, Ichinoseki-shi, Iwate 021-0902 (JP)
(74) Representative: Plougmann Vingtoft a/s
(86) International application number: PCT/JP2020/033453
(87) International publication number: WO 2021/049417

(57) **Abstract**

The present invention provides means capable of detecting a force acting on an upper part of an endless belt of the treadmill from a subject on the upper part of the belt even in a treadmill in which the height of a lower space below the upper part of the endless belt is limited. A treadmill comprises an endless belt 6 entrained about a front roller 4 and a rear roller 5 and a support plate 3 provided below an upper part 60 of the endless belt 6 and on which the upper part 60 of the endless belt 6 runs. The support plate 3 comprises a plurality of piezoelectric elements P inside the support plate 3 and/or on a surface of the support plate 3 so as to detect a force acting on the support plate 3 from the upper part 60 of the endless belt 6.

## Description

### Technical Field

The present invention relates to a treadmill.

### Background of the Invention

A treadmill is a device that enables indoor running and walking in which a subject performs a running motion and a walking motion on an upper part of an endless running belt (running belt), and is used for training or rehabilitation, for example. The treadmill is originally provided with a running function including the adjustment of the running speed of the belt, but there is also a treadmill having a measuring function in addition to the running function.

As the measuring function, it is useful to measure the ground reaction force of the subject walking or running on the running belt of the treadmill. A treadmill with a built-in force plate can be illustrated below. Patent Documents 1 to 4 disclose a treadmill provided with a force plate using a strain gauge. Patent Documents 5 to 6 disclose a treadmill provided with a force plate using a capacitance sensor. Patent Document 7 discloses a treadmill including a crystal-type force sensor capable of detecting orthogonal force components in three directions, and the force sensor is positioned below an endless belt assembly and fixed to the floor support plate.

The applicant has developed a treadmill with a low profile, that is, a thin treadmill having a low height from a floor to the upper part of the running belt (a walking surface or a running surface), for example, the height from the floor to the running belt is about 35 mm (Patent Documents 8 to 10). Such a low profile treadmill allows a subject (especially a patient or an aged person undergoing rehabilitation) to easily get on and off the upper part of the running belt, and has an advantage that an impact is reduced when the subject falls from the running belt to the floor during walking.

In such a low profile treadmill, the height of the space below the upper portion of the running belt is limited. In a treadmill provided with the conventional force plate, a sufficient space is secured below the upper part of the running belt so that a problem and an idea of storing the force plate in a space of an extremely limited height have not existed. In particular, the force plate using the load cells (strain gauge) has a structure that supports the force plate from below the support plate on which the load acts, so that the height dimension of the force plate is increased accordingly.

### Citation List

### [Patent Document]

[1] U.S. Patent No. 4830021
[2] Japanese Patent No. 5930389
[3] Japanese Patent No. 6187208
[4] Japanese Unexamined Patent Publication No. 2018-139975
[5] US Pat. No. 6,010465
[6] US Pat. No. 8,002672
[7] US Pat. No. 6,173,608
[8] Japanese Patent Application Patent Publication No. 2002-85586
[9] Japanese Patent Application Patent Publication No. 2005-245900
[10] Japanese Unexamined Patent Publication No. 2018-121962

### Summary of the Invention

The present invention seeks to provide means capable of detecting a force acting on an upper part of an endless belt of the treadmill from a subject on the upper part of the belt even in a treadmill in which the height of a lower space below the upper part of the endless belt is limited.

The present invention relates a treadmill comprising: an endless belt entrained about a front roller and a rear roller; and a support plate provided below an upper part of the endless belt and on which the upper part of the endless belt runs, wherein the support plate comprises a plurality of piezoelectric elements inside the support plate and/or on a surface of the support plate so as to detect a force acting on the support plate from the upper part of the endless belt.

In one aspect, as the piezoelectric element, a piezoelectric vibration plate (a piezoelectric bonded to a metal plate such as brass or nickel), a piezoelectric ceramic, a crystalline piezoelectric element, or an element in which a soft magnetic material and a magnetostrictive material are bonded (WO2018/230154) can be exemplified. Preferably, the thickness of the piezoelectric element is 1 mm or less, for example, 0.6 mm or less. When the piezoelectric element is provided in the support plate, it is desirable to employ a thinner piezoelectric element in order not to affect the thickness of the support plate.

In one aspect, the support plate comprises an upper portion and a lower portion, and the plurality of piezoelectric elements are provided between the upper portion and the lower portion. The upper portion of the support plate comprises one or a plurality of sheets. In one aspect, an upper portion of the support plate is formed by laminating an upper wooden sheet and a lower metal (for example, iron or steel) sheet. A lower portion of the support plate comprises one or a plurality of sheets. In one aspect, the lower part of the support plate is formed of a top metal (for example, iron or steel) sheet, one or a plurality of intermediate wooden sheets (for example, veneer sheet) and a bottom metal sheet (for example, iron or steel). The piezoelectric elements are provided in the support plate in such a manner that the force acting on the support plate from above can be detected. Specifically, a lower surface of the piezoelectric element is in contact with the upper surface of the lower portion directly or indirectly (for example, via an element such as a pusher described later), and an upper surface of the piezoelectric element is in contact with the lower surface of the upper portion directly or indirectly (for example, via an element such as a pusher described later). The upper portion and the lower portion of the support plate may be integrated by providing a spacer between the lower surface of the upper portion and the upper surface of the lower portion.

In one aspect, an intermediate sheet is provided between the upper portion of the support plate and the lower portion of the support plate, a plurality of openings are formed in the intermediate sheet, and each piezoelectric element is housed in each opening. In one aspect, the intermediate sheet is made of a metal (for example, made of iron, steel or aluminum). In one aspect, the lower surface of the piezoelectric element housed in each opening is brought into contact with and fixed (bonded) to the upper surface of the lower portion of the support plate. In one aspect, a pusher is provided between the upper surface of the piezoelectric element and the lower surface of the upper portion of the support plate. In one aspect, the lower surface of the upper portion and the intermediate sheet are made of metal, and the pusher is made of an insulator (for example, made of plastic material). In one aspect, the thickness of the intermediate sheet (depth of the opening) is greater than the height (thickness) of the piezoelectric element, and the lower portion of the pusher is positioned within the opening, and the remaining upper portion is positioned above the upper surface of the intermediate sheet. In one aspect, the upper portion and the intermediate sheet are fixed by providing a spacer between the lower surface of the upper portion and the upper surface of the intermediate sheet. In one aspect, a number of openings are formed in the intermediate sheet in which some openings accommodate a piezoelectric element and other remaining openings accommodate a dummy plate. In one aspect, the dummy plate has substantially the same height dimension as the piezoelectric element. In one aspect, the dummy plate is made of the same material as the intermediate sheet, and for example, if the intermediate sheet is made of iron, the dummy plate is made of iron. In one aspect, a number of openings are formed in the intermediate sheet at intervals in the front-rear direction and the left-right direction of the support plate.

In one aspect, a wiring of the plurality of piezoelectric elements extends inside the support plate or along a lower surface of the support plate. In one aspect, the wiring extends between an upper portion and a lower portion of the support plate, inside the lower portion, or along a lower surface of the lower portion. In one aspect, the lower portion of the support plate has a laminated structure comprising a plurality of sheets in which the top sheet has holes located immediately below the piezoelectric elements (openings formed in the intermediate sheet), and a sheet immediately below the top sheet has grooves located immediately below the holes. The wiring of the piezoelectric element may be formed of a flexible substrate, for example, the flexible substrate extends between the upper portion and the lower portion. A signal (output voltage) from the piezoelectric element may be wirelessly transmitted to a processing unit.

In one aspect, the support plate comprises a portion facing the upper part of the endless belt and a non-opposing portion not facing the upper part of the endless belt, and a plurality of piezoelectric elements are provided on the surface of the non-opposing portion. In one aspect, the piezoelectric element detects vibration of the support plate when a force acts on the support plate, and is, for example, a flexible ultrathin film (for example, a piezoelectric PVDF polymer film). In one aspect, the plurality of piezoelectric elements are in contact with only the support plate. "Contacting only the support plate" means that it is not in contact with the structure other than the support plate of the treadmill or the floor surface, but the contact of the piezoelectric element to means for fixing the piezoelectric element to the support plate is not excluded. The support plate may be provided with an element for protecting a piezoelectric element provided on the surface of the support plate. In one aspect, the width of the upper surface of the support plate is larger than the width of the endless belt, the upper surface comprises the non-opposing portion, and the plurality of piezoelectric elements are provided on the non-opposing portion of the upper surface. In one aspect, the non-opposing portion of the upper surface comprises widthwise side portions that are not located below the upper part of the endless belt. When the left and right independent endless belts are provided and there exists a gap between the left and right endless belts, the non-opposing portion on the upper surface comprises a central portion of the upper surface positioned between the upper portions of the left and right endless belts, and the piezoelectric elements may be provided on such a portion. Further, the lower surface and the end surfaces of the support plate are the non-opposing portions, and the plurality of piezoelectric elements may be provided on the lower surface or the end surfaces.

According to the present invention, by providing a plurality of piezoelectric elements inside the support plate and/or surfaces of the support plate so as to detect the force acting on the support plate from the upper part of the endless belt, the force acting on the support plate can be detected even in the treadmill in which the height of the lower space below the upper part of the endless belt is limited.

### Brief Description of the Drawings

FIG. 1 is a perspective view of a treadmill according to an embodiment.
FIG. 2 is a transverse sectional view of a main part of the treadmill according to the present embodiment.
FIG. 3 is a longitudinal sectional view of a main part of the treadmill according to the present embodiment.
FIG. 4 is a perspective view of a treadmill according to another embodiment.
FIG. 5 is an exploded perspective view of a machine base and a support plate of the treadmill according to the embodiment.
FIG. 6 is a partial cross-sectional view of a support plate of the treadmill according to the present embodiment.
FIG. 7 is a partial exploded perspective view of a support plate of the treadmill according to the present embodiment.
FIG. 8 is a partial enlarged view of FIG. 6 showing a piezoelectric element.
FIG. 9 is a partial enlarged view of FIG. 6 showing a dummy plate.
FIG. 10 shows some variations of the embodiment of the support plate according to the present invention.
FIG. 11 shows other embodiments of a support plate provided with piezoelectric elements.
FIG. 12 is a block diagram showing a flow of a signal acquired by the piezoelectric elements.

### Description of the Embodiments

### [A] Basic Configuration of Treadmill

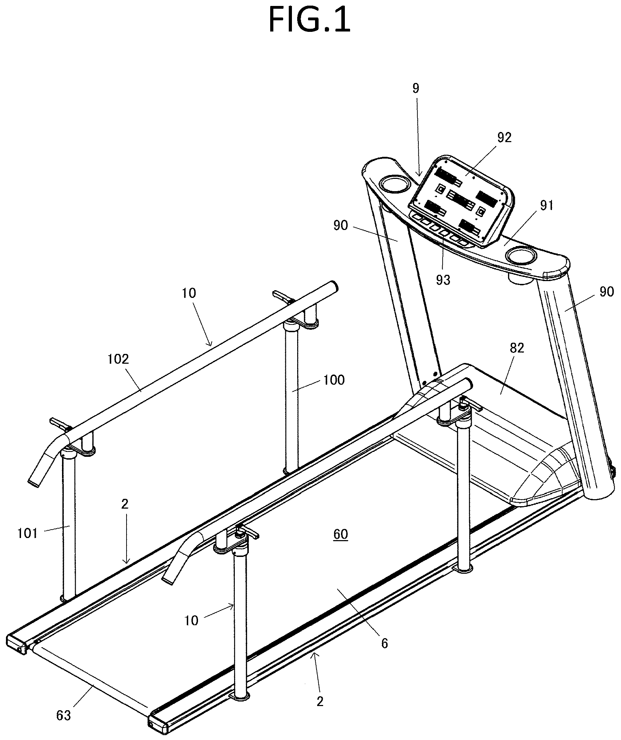

A basic configuration of a treadmill according to the present embodiment will be described with reference to FIGS. 1 to 3. The treadmill comprises a machine base having a front base 1 and left and right side frames 2, a support plate 3 supported between the left and right side frames 2, a front roller (driving roller) 4 positioned at a front of the support plate 3 and rotatably provided on the front base 1, a rear roller (driven roller) 5 positioned at a rear of the support plate 3 and rotatably provided between the left and right side frames 2, and an endless belt (running belt) 6 entrained about the front roller 4 and the rear roller 5 and running above and below the support plate 3.

The endless belt 6 is, for example, a flexible plastic endless belt, and comprises an upper part 60 running along an upper side of the support plate 3, a lower part 61 running along a lower side of the support plate 3, a front engagement portion 62 wound around the front roller 4, and a rear engagement portion 63 wound around the rear roller 5. The upper part 60 of the endless belt 6 forms a walking surface or a running surface on which a subject stands.

The front roller 4 has a larger diameter than that of the rear roller 5, and a pressing roller 7 is provided between the front end of the support plate 3 and the front roller 4 that is positioned forwardly obliquely upward from the front end of the support plate3. The upper part 60 of the endless belt 6 extends horizontally in the front-rear direction, and a transition portion 64 between the upper part 60 and the front engagement portion 62 is pressed downward by the pressing roller 7 and extends forwardly in an upward inclined state. By pressing the front portion of the upper part 60 of the endless belt 6 to the lower part 61 by the pressing roller 7, the upper part 60 and the lower part 61 extend in parallel at a narrow distance (smaller than the diameter of the front roller 4).

A drive mechanism 8 comprising a drive motor 80 and a transmission mechanism 81 is mounted on the front base 1, and the endless belt 6 runs by transmitting the rotational force of the drive motor 80 to the front roller 4 by the transmission mechanism 81. The drive mechanism 8 is covered with a cover 82.

A front frame 9 is provided at the front end of the left and right side frames 2. The front frame 9 comprises front support posts 90 positioned at the front end of the left and right side frames 2, and an upper frame 91 connecting the upper ends of the front support posts 90. The upper frame 91 is provided with a display 92 and an operation unit 93. Handrail frames 10 are provided at sides of the left and right side frames 2. The handrail frame 10 comprises a front support 100 and a rear support 101, and a handrail bar 102 connecting the front and rear supports 100 and 101. The shapes and configurations of the front frame 9 and the handrail frame 10 are not limited to those shown in the drawing.

The side frame 2 is an elongated member extending in the front-rear direction and comprises a lower side frame body 20 and an upper side cover 21. In one embodiment, the side frame body 20 and the side cover 21 are made of aluminum. A side step 22 made of plastic material is provided on the upper surface of the side cover 21, and a frame rubber 23 made of rubber is provided below the side frame body 20. The shape and configuration of the side frame 2 are not limited to those shown in the drawing, and the material of the elements constituting the side frame 2 is not limited.

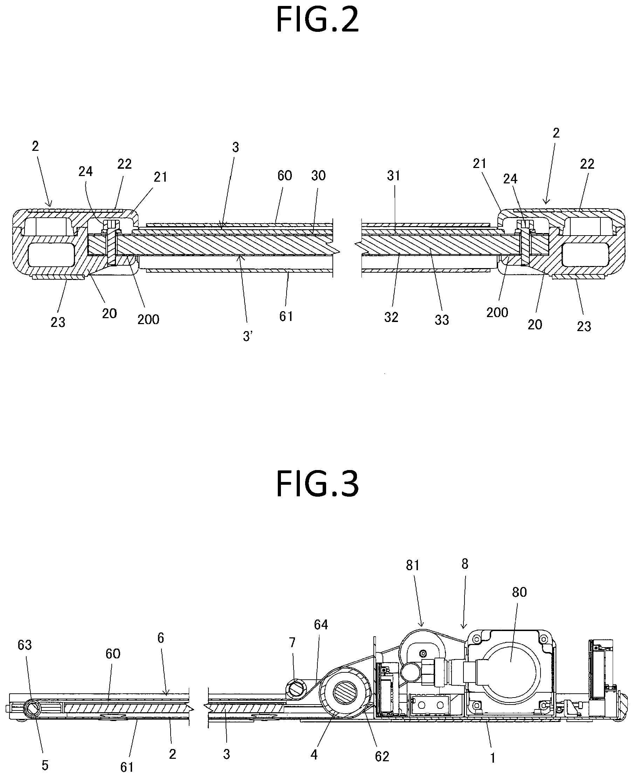

The support plate 3 comprises a top layer 30 and a base plate 3' positioned below the top layer 30. The top layer 30 is positioned immediately below an upper part of the endless belt 6 and on which an upper part of the endless belt runs. The base plate 3' according to the present embodiment is wider than the top layer 30, and both side portions in the width direction of the base plate 3' are exposed without being covered by the top layer 30. The support plate 3 is fixed to the side frame main body 20 by mounting bolts 24 in a state where the lower surfaces of both end portions in the width direction of the base plate 3' are placed on the horizontal support surface 200 of the side frame main body 20. As shown in FIG. 2, the mounting bolts 24 penetrate the base plate 3' at both end portions in the width direction, but do not penetrate the top layer 30.

The top layer 30 of the support plate 3 forms a sliding contact surface, and the support plate 3 is positioned between the upper part 60 and the lower part 61 of the endless belt 6, and slidably supports the upper part 60 of the endless belt 6. The top layer 30 of the support plate 3 is formed of a material having good slipperiness, for example, and is formed by impregnating a polished surface of the wooden sheet with silicone or the like.

In the embodiment shown in FIG. 2, the base plate 3' comprises an upper metal sheet 31, a lower metal sheet 32, and an intermediate layer 33 sandwiched between the upper and lower metal sheets 31 and 32. The material of the intermediate layer 33 is not limited, but is formed from, for example, one or a plurality of veneer sheets. The base plate 3' is formed by sandwiching the intermediate layer 33 between the upper and lower metal sheets 31 and 32, so that the strength is secured while suppressing the thickness of the base plate 3'. As will be described later, in an embodiment in which piezoelectric elements P are provided inside the support plate 3, the intermediate layer 33 between the upper and lower metal sheets 31 and 32 may have a laminated structure of a plurality of sheets.

A treadmill according to the present embodiment has a low profile, that is, a thin shape. In one aspect, the thickness of the support plate 3 is at least 20 mm or less. The pressing roller 7 can keep the distance between the upper part 60 and the lower part 61 of the endless belt 6 smaller than the diameter of the front roller 4, and a thin treadmill as a whole is provided in conjunction with the small diameter rear roller 5 and the thin support plate 3. In one aspect, the height from the floor surface on which the treadmill is installed to the upper part 60 (walking surface or running surface) of the endless belt 6 is set to 40 mm or less, for example, 35 mm. In the illustrated embodiment, the treadmill can be made thinner by using the pressing roller 7, but the driving means of the endless belt 6 is not limited to the one using the pressing roller 7. For example, it is possible to construct a thin treadmill by using a front roller and a rear roller having a small diameter. Further, the present invention is not limited to the thin treadmill and can be widely applied to the treadmill in general.

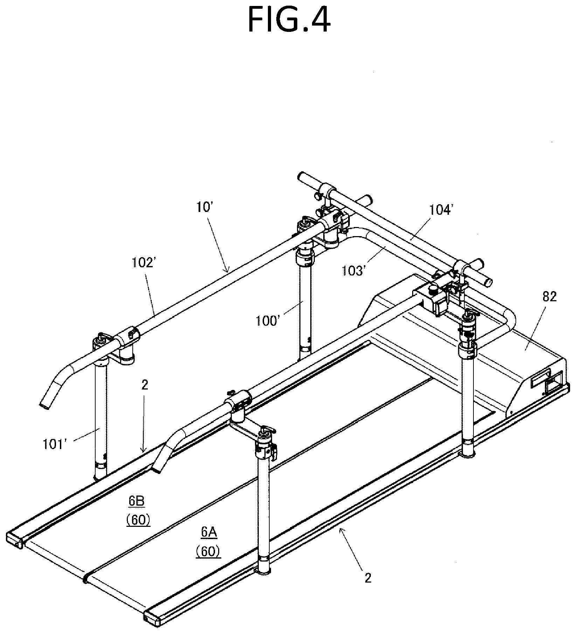

FIG. 4 shows another embodiment of the thin treadmill, which includes two endless belts running in parallel (an endless belt 6A for the right foot and an endless belt 6B for the left foot). The present invention can be applied to a treadmill of a type as shown in FIG. 4. In FIG. 4, the handrail frame 10' comprises front and rear supports 100', 101', and handrail bars 102' for connecting the front and rear supports 100', 101', and the upper parts of the left and right front supports 100' are connected by a connecting frame 103' having a U-shaped plan view configuration. A front bar 104' extends between the front ends of the left and right handrail bars 102'. The shape and configuration of these frames are examples. The treadmill provided with the endless belt 6A for the right foot and the endless belt 6B for the left foot is known and is disclosed in, for example, Patent Document 2 and Patent Document 7, and for a specific configuration, the description of Patent Document 2 and Patent Document 7 can be referred to.

### [B] Configuration of Support Plate Provided with Piezoelectric Elements

The treadmill according to the present embodiment comprises the endless belt 6 entrained about the front roller 4 and the rear roller 5 and the support plate 3 which is provided below the upper part 60 of the endless belt 6 and on which the upper part 60 the endless belt 6 runs in which a plurality of piezoelectric elements P are provided inside the support plate 3 and/or on a surface of the support plate 3 so as to detect the force acting on the support plate 3 from the upper part 60 of the endless belt 6 when the subject walks or runs on the upper part 60 of the endless belt 6.

### [B-1] Configuration in which Piezoelectric Elements Provided inside Support Plate

In one embodiment, the support plate 3 comprises an upper portion 3A and a lower portion 3B, and the plurality of piezoelectric elements P are provided between the upper portion 3A and the lower portion 3B so as to detect force acting on the upper surface of the upper portion 3A. Typically, the upper portion 3A of the support plate 3 comprises an upper surface facing the upper part 60 of the endless belt 6 and a lower surface. The lower portion 3B comprises an upper surface and a lower surface. The piezoelectric elements P are positioned between the lower surface of the upper portion 3A and the upper surface of the lower portion 3B. The upper portion 3A of the support plate 3 is formed of one or a plurality of sheets, and the lower portion 3B of the support plate 3 is formed of one or a plurality of sheets. The piezoelectric elements P are fixed to the lower surface of the upper portion 3A and/or the upper surface of the lower portion 3B in an immovable state (including fixing by bonding or a sandwiching force).

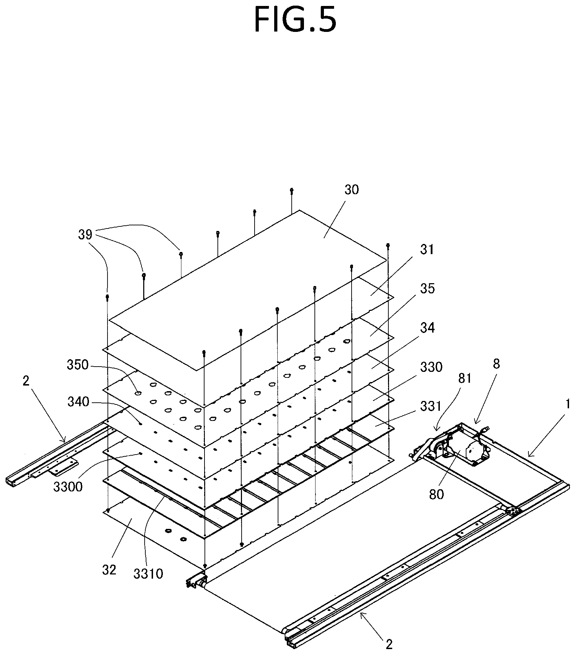

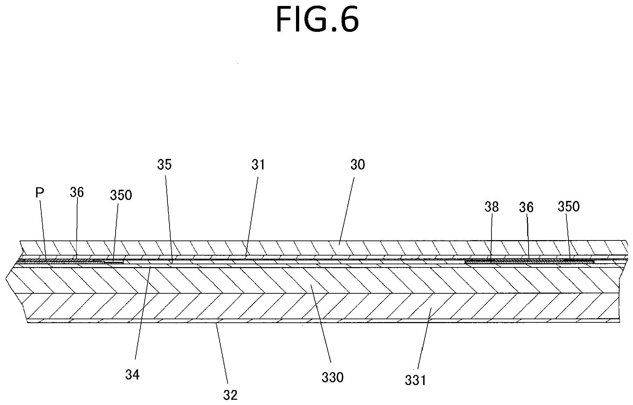

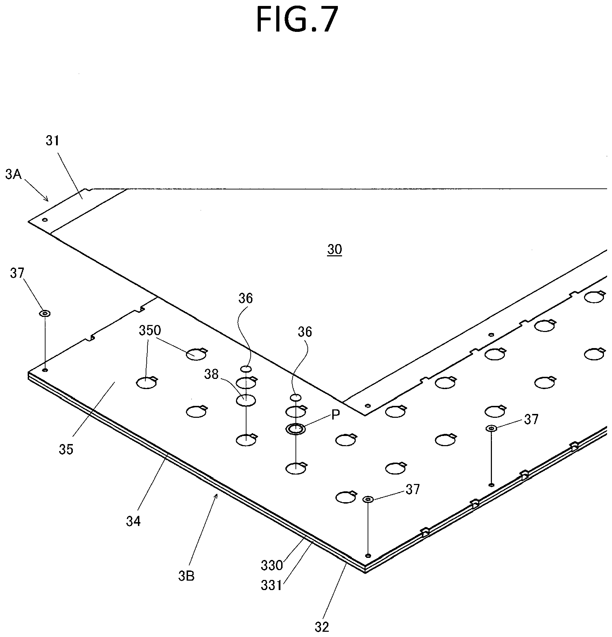

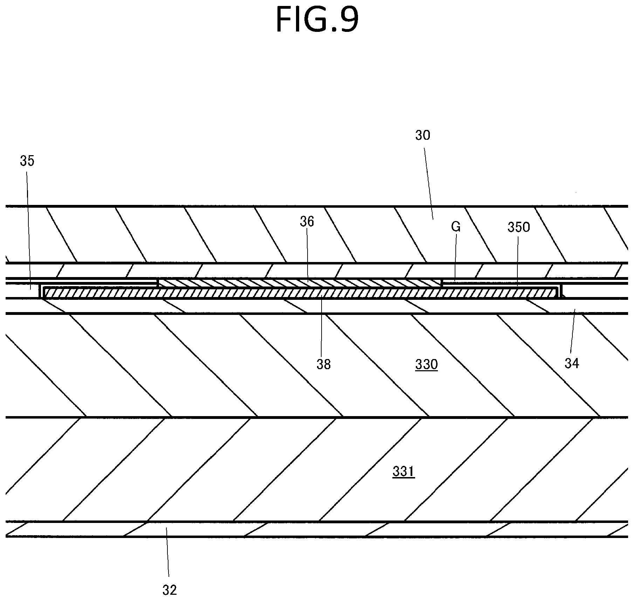

In the embodiment shown in FIGS. 5 to 9, the upper portion 3A of the support plate 3 is formed by bonding an upper wooden sheet forming the top layer 30 and a lower metal (for example, iron or steel) sheet 31.

The lower portion 3B of the support plate 3 is formed by bonding a top metal (for example, iron or steel) sheet 34, two intermediate wooden sheets (for example, base plates) 330, 331, and a bottom metal sheet 32.

In the embodiment shown in FIGS. 5 to 9, an intermediate sheet 35 made of metal (for example, made of iron or steel or aluminum) is provided between the lower surface of the upper portion 3A and the upper surface of the lower portion 3B of the support plate 3. A plurality of openings 350 are formed at predetermined positions of the intermediate sheet 35, and the piezoelectric element P is housed in each of the openings 350. More specifically, the upper surface of the lower portion 3B of the support plate 3 serves as the bottom of the opening 350 formed in the intermediate sheet 35, and the piezoelectric element P is positioned in the opening 350 and is fixed (for example, bonded) in a state where the piezoelectric element P rests on the upper surface of the lower portion 3B of the support plate 3.

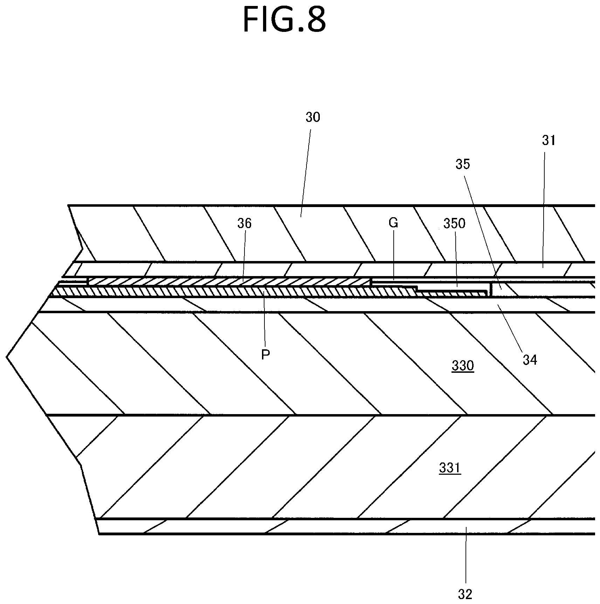

In the present embodiment, the height (thickness) of the piezoelectric element P is slightly smaller than the thickness of the intermediate sheet 35, and the pusher 36 is arranged on the upper surface of the piezoelectric element P housed in the opening 350 of the intermediate sheet 35. In one embodiment, the pusher 36 is fixed (bonded or the like) to the upper surface of the piezoelectric element P. The shape of the pusher 36 is not limited, but is, for example, a thin circular plate, in which the lower surface of the pusher 36 abuts on the upper surface of the piezoelectric element P, and the lower surface of the upper portion 3A abuts on the upper surface of the pusher 36. That is, the lower portion of the pusher 36 is positioned in the opening 350, the upper portion of the pusher 36 is positioned above the upper surface of the intermediate sheet 35, and the lower surface of the upper portion 3A and the upper surface of the lower portion 3B of the support plate 3 are slightly separated from each other to form a gap G (see FIG. 8). In one embodiment, the pusher 36 is formed of an insulator, for example made of plastic material.

A plurality of spacers 37 are provided between the lower surface of the upper portion 3A of the support plate 3 and the upper surface of the intermediate sheet 35, for example, spaced apart along the peripheral edge including the corner portions, so as to secure the gap G.

In one embodiment, a number of openings 350 are provided in the intermediate sheet 35 in which some of the openings 350 are provided with the piezoelectric element P, and the other remaining openings 350 are not provided with the piezoelectric element P. For example, the openings 350 are formed in a grid pattern with intervals in the vertical and horizontal directions on the intermediate sheet 35 in which predetermined openings 350 are selected and the piezoelectric elements P are housed in the selected openings 350. A dummy plate 38 is housed in the opening 350 in which the piezoelectric element P is not housed so as to fill the opening 350. In one embodiment, the dummy plate 38 has the same height as the piezoelectric element P, and a pusher 36 is provided between the upper surface of the dummy plate 38 and the lower surface of the upper portion 3A. In one embodiment, the dummy plate 38 is formed of the same material as the intermediate sheet 35, and for example, if the intermediate sheet 35 is made of iron, the dummy plate 35 is made of iron.

Perforations 340 are formed in the top metal sheet 34 of the lower portion 3B forming the bottom surface of the opening 350 of the intermediate sheet 35 and are located at the bottoms of the openings. Perforations 3300 are formed in the wooden sheet 330 immediately below the metal sheet 34 corresponding to the perforations 340. Grooves 3310 are formed on the upper surface of the wooden sheet 331 immediately below the wooden sheet 330 and located below the perforations 3300. The perforations 340, the perforations 3300, and the grooves 3310 formed in the lower portion 3B of the support plate 3 form a wiring path for the piezoelectric elements P. In the aspect shown in FIG. 5, the groove 3310 extends over the entire width of the support plate 3, and a wiring (not shown) guided by the groove 3310 is connected to, for example, a processing unit (not shown) provided on the front base 1 through a space in one or both side frames 2. The direction in which the groove 3310 extends is not limited to the width direction as shown in the drawing, and the layer and position in which the perforations and grooves are formed in the support plate 3 are not limited.

As shown in FIG. 5, the support plate 3 according to the present embodiment is formed by superposing a wooden sheet (top layer 30), a metal sheet 31, a metal intermediate sheet 35, a metal sheet 34, a wooden sheet 330, a wooden sheet 331, and a metal sheet 32, in this order from the top. An upper portion 3A of the support plate 3 is formed by bonding the wooden sheet (top layer 30) and the metal sheet 31 with an adhesive. A lower portion 3B of the support plate 3 is formed by bonding the metal sheet 34, the wooden sheet 330, the wooden sheet 331, and the metal sheet 32 with an adhesive. The upper portion 3A and the lower portion 3B are fixed by using screws 39 with the intermediate sheet 35 being sandwiched between the lower surface of the upper portion 3A and the upper surface of the lower portion 3B. The screws 39 for integrating the support plate 3 and some or all of mounting bolts 24 for fixing the support plate 3 to the side frame 2 may be commonly used. In the support plate 3, the metal sheet 31, the metal intermediate sheet 35, the metal sheet 34, the wooden sheet 330, the wooden sheet 331, and the metal sheet 32 form a base plate 3' of the support plate 3, and the top layer 30 made of a wooden sheet is formed on the upper surface of the base plate 3 '.

The thickness of each sheet forming the support plate 3 is, for example, 1 mm to 3 mm for the wooden sheet (top layer 30), about 1 mm for the metal sheet 31, the metal intermediate sheet 35, the metal sheet 34, and the metal sheet 32, and about 5 mm for the wooden sheet 330 and the wooden sheet 331.

In a case where the top layer 30 of the support plate 3 is formed of a wooden sheet, when the top layer 30 is warped by drying, the metal sheet 31 bonded to the top layer 30 is warped, and the piezoelectric element P and the metal sheet 31 are not brought into close contact with each other, and the responsiveness of the piezoelectric element P in walking or the like is deteriorated, and an accurate load may not be obtained. In one embodiment, the wooden sheet (the top layer 30) has a thickness of 1 mm or less, and the metal sheet 31 has the strength enough to prevent deformation (warpage) of the wooden sheet (that is, to maintain the flatness of the wooden sheet and the metal sheet 31 itself). The warpage of the wooden sheet and the metal sheet 31 may be prevented by attracting the metal sheet 31 (made of iron or steel) forming the lower surface of the upper portion 3A of the support plate 3 to the lower portion 3B by a magnetic force. The magnet may be provided, for example, on the metal sheet 34 of the lower portion 3B, but the magnet may be provided on the intermediate sheet 35, or the magnet may be provided on the metal sheet 31 so as to attract the intermediate sheet 35 (iron or steel) and the metal sheet 34 (made of iron or steel) of the lower portion 3B.

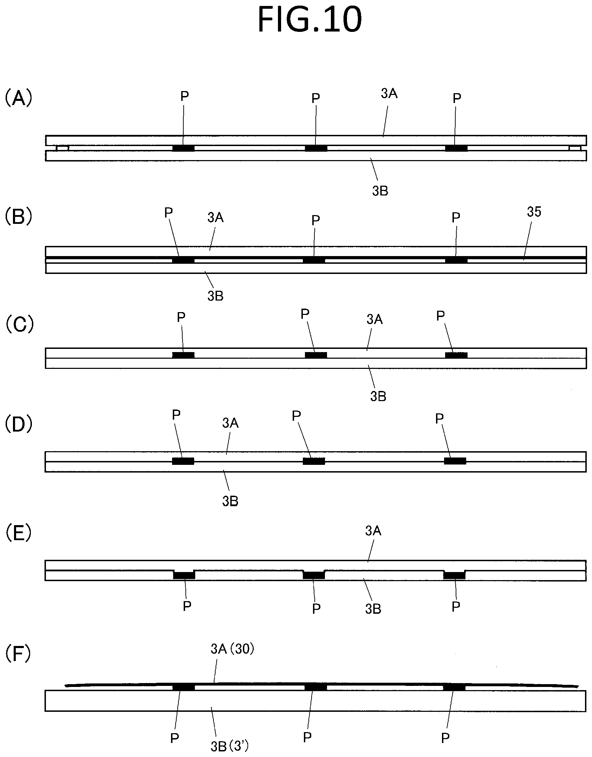

FIG. 10 shows non-limiting variations of the embodiment in which a plurality of piezoelectric elements P are provided between the upper portion 3Aand the lower portion 3B of the support plate 3. When a plurality of piezoelectric elements P are provided in the support plate 3, the arrangement of piezoelectric elements P is not limited to the embodiment shown in FIGS. 5 to 9 provided that the piezoelectric elements P are provided in such a manner that the force acting on the support plate 3 from the upper part 60 of the endless belt 6 can be detected. When the plurality of piezoelectric elements are provided inside the support plate 3, preferably, a plurality of piezoelectric elements P are provided at a distance from each other in the plane direction (direction parallel to the XY plane) of the support plate 3 at the same depth position.

In the embodiment shown in FIG. 10A, the lower surface of the piezoelectric element is in contact with the upper surface of the lower portion 3B, and the lower surface of the upper portion 3A is in contact with the upper surface of the piezoelectric element. Spacers 37 are provided at the peripheral edges of the lower surface of the upper portion 3A and the upper surface of the lower portion 3B. The embodiment shown in FIG. 10B is similar to the above-described embodiment shown in FIGS. 5 to 9, and an intermediate sheet 35 is provided between the upper portion 3A and the lower portion 3B, and a plurality of openings are formed in the intermediate sheet 35, and each piezoelectric element is housed in each opening. Pushers 36 and spacers 37 as described in the embodiment shown in FIGS. 5 to 9 may be provided. Instead of the pusher, a downward projecting part may be integrally formed on the lower surface of the upper portion 3A.

In the embodiment shown in FIG. 10C, downward concave portions are formed on the lower surface of the upper portion 3A, the lower surface of the piezoelectric element P abuts on the upper surface of the lower portion 3B, and the upper surface of the piezoelectric element P abuts on the lower surface of the upper portion 3A (the upper surface of the downward concave portion). In the embodiment shown in FIG. 10D, downward concave portions are formed on the lower surface of the upper portion 3A, and upward concave portions are formed on the upper surface of the lower portion 3B. The lower surface of the piezoelectric element P abuts on the upper surface (lower surface of the upward concave portion) of the lower portion 3B, and the upper surface of the piezoelectric element P abuts on the lower surface (upper surface of the downward concave portion) of the upper portion 3A. In the embodiment shown in FIG. 10E, downward convex portions are formed on the lower surface of the upper portion 3A, an upward concave portions are formed on the upper surface of the lower portion 3B. The lower surface of the piezoelectric element P abuts on the upper surface (lower surface of the upward concave portion) of the lower portion 3B, and the upper surface of the piezoelectric element P abuts on the lower surface (the downward convex portion) of the upper portion 3A. As shown in FIG. 10(C)-(E), the lower surface of the upper portion 3A and/or the upper surface of the lower portion 3B may not be an entirely flat surface and may comprise a concave or convex portion at a portion where the piezoelectric element P is to be provided. Also, in the embodiment shown in FIG. 10(C) to (E), the pusher 36 and the spacer 37 as described in the embodiments shown in FIGS. 5 to 9 may be provided.

In the embodiment shown in FIG. 10F, the support plate 3 comprises a base plate 3' (lower portion 3B) and a top layer 30 (upper portion 3A) provided so as to cover the upper surface of the base plate 3'. A plurality of piezoelectric elements P are provided between the upper surface of the base plate 3' and the lower surface of the top layer 30. More specifically, a plurality of piezoelectric elements P are fixed (bonded or the like) at a predetermined positions on the upper surface of the base plate 3', and the top layer 30 is provided so as to cover the upper surface of the piezoelectric elements P and the base plate 3 '. In this embodiment, the top layer 30 is formed of a plastic film or the like having good slipperiness.

In FIG. (A) to (F), the piezoelectric elements P are fixed to the lower surface of the upper portion 3A and/or the upper surface of the lower portion 3B in an immovable state (including fixing by bonding or a sandwiching force). In FIG. 10(A) to (F), a wiring for outputting a signal from the piezoelectric element P is omitted. The output of the signal from the piezoelectric element P is not limited to the one using a wired connection and may be output wirelessly. In one aspect, the plurality of piezoelectric elements P may be integrally formed on a flexible substrate, and the signal from the piezoelectric element P may be output via the flexible substrate. For example, a flexible substrate comprising the piezoelectric elements P may be provided between the upper portion 3A and the lower portion 3B of the support plate 3.

### [B-2] Configuration in which Piezoelectric Elements Provided on Surface of Support Plate

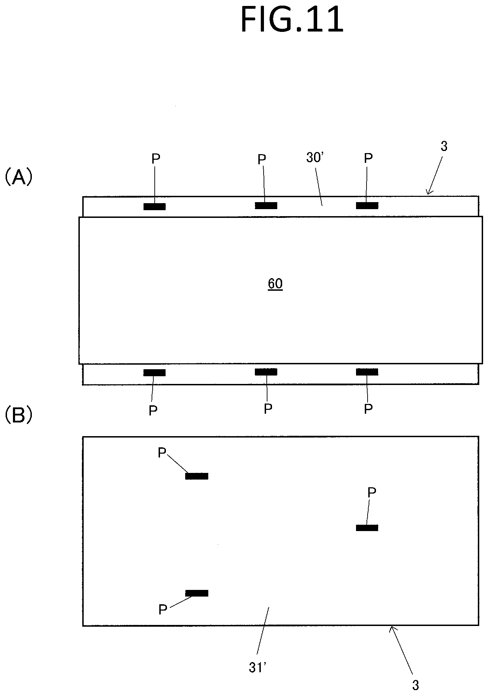

Although the configuration in which the piezoelectric elements P are provided inside the support plate 3 has been described, the piezoelectric elements P may be provided on the surface of the support plate 3. This embodiment will be described with reference to FIG.11(A) and (B). The support plate 3 comprises a portion facing the upper part 60 of the endless belt 6 and a non-opposing portion not facing the upper part 60 of the endless belt 6. Inherently, the upper surface of the support plate 3 includes a portion facing the upper part 60 of the endless belt 6. In the present embodiment, a plurality of piezoelectric elements P are provided on the surface of the non-opposing portion that does not face the upper part 60 of the endless belt 6. The piezoelectric element P detects vibration of the support plate 3 when force acts on the support plate 3

In the embodiment shown in FIG. 11A, the width of the upper surface of the support plate 3 (base plate 3') is larger than the width of the endless belt 6 (upper part 60), and widthwise side portions 30' of the upper surface are non-opposing portions not positioned below the upper part 60 of the endless belt 6. The piezoelectric elements P are fixed (bonded or the like) to the widthwise side portions 30' (non-opposing portions) on the upper surface of the support plate 3.

The lower surface 31' and the end surfaces of the support plate 3 (base plate 3') are non-opposing portions that do not face the upper part 60 of the endless belt 6, and a plurality of piezoelectric elements P may be provided on the lower surface 31' or the end surfaces of the support plate 3. FIG. 11B shows an embodiment in which a plurality of piezoelectric elements P are fixed (bonded or the like) to the lower surface 31' of the support plate 3 (base plate 3'). Further, the left and right independent endless belts 6A and 6B are provided (see FIG. 4). When a non-opposing portion which is not opposed to the upper portions of the endless belts 6A and 6B is formed between the upper portions of the left and right endless belts 6A and 6A, the piezoelectric elements may be provided on such a portion.

The piezoelectric element P detects vibration of the support plate 3 when the force acts on the support plate 3, and in one embodiment, the plurality of piezoelectric elements P are in contact with only the support plate 3. The "contact with only the support plate" means that it is not in contact with a structure other than the support plate of the treadmill or a floor surface, but the contact of the piezoelectric element P to means for fixing the element P to the support plate 3 is not excluded. An element for protecting the piezoelectric element P provided on the surface of the support plate 3 may be provided on the surface of the support plate 3. Although it may be possible that the piezoelectric element P detects vibration transmitted from a frame such as a handrail to the support plate 3, an output voltage (signal) due to the vibration other than walking may be converted into data by an experiment in advance, and the output voltage from the piezoelectric element P may be corrected by canceling a noise due to vibration other than walking.

### [C] Detection of Ground Reaction Force Using Piezoelectric Elements

The piezoelectric element is an element that converts the force applied to the piezoelectric body into a voltage and converts the force acting on the support plate 3 into a voltage and outputs the voltage. Examples of the piezoelectric element include a piezoelectric vibrating plate (a piezoelectric element bonded to a metal plate such as brass or nickel), a piezoelectric ceramic, a crystalline piezoelectric element, and an element obtained by joining a soft magnetic material and a magnetostrictive material (see WO2018/230154) can be exemplified. When the piezoelectric element P is provided inside the support plate 3, the thickness of the piezoelectric element is not limited, but is preferably 1 mm or less, more preferably 0.6 mm or less. The piezoelectric element may be a sheet-like body (for example, formed from a flexible substrate) in which a plurality of piezoelectric elements are arranged in an array. When the piezoelectric element is provided on the surface of the support plate 3, the piezoelectric element detects the vibration of the support plate in which the piezoelectric element is a very thin film having flexibility (for example, a piezoelectric PVDF polymer film).

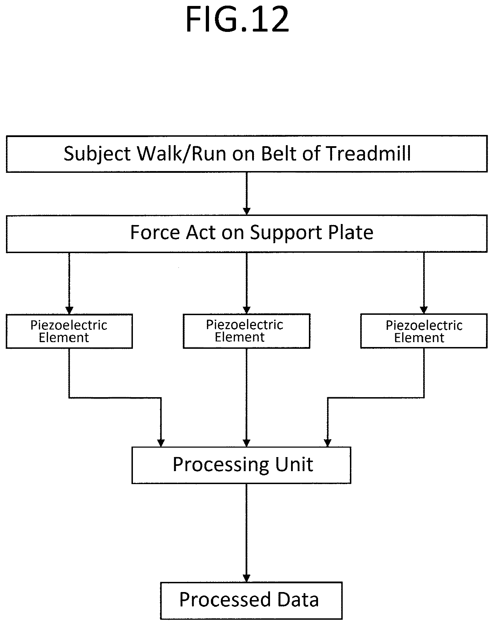

FIG. 12 shows the flow of the signal acquired by the piezoelectric element. When the subject standing on the upper part 60 of the endless belt 6 of the treadmill performs a walking motion or a running motion, a force acts on the support plate 3 located immediately below the upper part 60. The force acting on the support plate 3 is detected by a plurality of piezoelectric elements P provided on the support plate 3, and a signal (output voltage) is output from each piezoelectric element P and transmitted to the processing unit by wire or wirelessly. In the processing unit, a predetermined calculation is executed using the output voltages from the plurality of received piezoelectric elements P, and the processed data is output. The processing unit may be mounted on the treadmill or may be provided separately from the treadmill. The piezoelectric element P according to the present embodiment detects a force in the vertical direction, and the processed data can be used, for example, in combination with other measurement data (for example, motion data of the subject). When the endless belt 6 is rotated, a noise may be generated due to contact between the support plate 3 and the endless belt 6 (particularly, a step at the belt joint portion), but the noise synchronized with the rotation of the endless belt 6 may be canceled.

### List of Reference Numbers

3 Support plate
3' Base plate
3A Upper portion
3B Lower portion
30 Top layer (upper portion)
31 Metal sheet (upper portion)
32 Metal sheet (lower portion)
330 Wooden sheet (lower portion)
331 Wooden sheet (lower portion)
34 Metal sheet (lower portion)
35 Intermediate sheet
36 Pusher
37 Spacer
38 Dummy plate
39 Screw
30' Widthwise side portions of baseplate (non-opposing portion)
31' Lower surface of base plate (non-opposing portion)
4 Front roller
5 Rear roller
6 Endless belt
60 Upper part
61 Lower part
P Piezoelectric element
G Gap

## Claims

1. A treadmill comprising:
an endless belt entrained about a front roller and a rear roller; and
a support plate provided below an upper part of the endless belt and on which the upper part of the endless belt runs, wherein
said support plate comprises a plurality of piezoelectric elements inside the support plate and/or on a surface of the support plate so as to detect a force acting on the support plate from the upper part of the endless belt.

2. The treadmill according to claim 1, wherein the support plate comprises an upper portion and a lower portion, and the plurality of piezoelectric elements are provided between the upper portion and the lower portion.

3. The treadmill according to claim 2, wherein an intermediate sheet is provided between the upper portion and the lower portion, and wherein a plurality of openings are formed in the intermediate sheet, and each piezoelectric element is housed in each of the openings.

4. The treadmill according to claim 2 or 3, wherein a wiring of the plurality of piezoelectric elements extends inside the support plate or along a lower surface of the support plate.

5. The treadmill according to claim 1, wherein the support plate comprises a portion opposing the upper part of the endless belt and a non-opposing portion not facing the upper part of the endless belt, and the plurality of piezoelectric elements are provided on a surface of the non-opposing portion.

6. The treadmill according to claim 5, wherein a width of an upper surface of the support plate is larger than a width of the endless belt, the upper surface of the support plate comprises the non-opposing portion, and the piezoelectric elements are provided on the non-opposing portion of the upper surface.

7. The treadmill according to claims 5 or 6, wherein the non-opposing portion comprises a lower surface and end surfaces of the support plate, and the piezoelectric elements are provided on the lower surface and/or the end surfaces.
